(19) Europäisches Patentamt
European Patent Office
Office européen des brevets

(11) **EP 3 666 922 A1**

(12) **EUROPEAN PATENT APPLICATION**
published in accordance with Art. 153(4) EPC

(43) Date of publication:
**17.06.2020  Bulletin 2020/25**

(21) Application number: **18843826.1**

(22) Date of filing: **26.07.2018**

(51) Int Cl.:
**C23C 14/08** (2006.01)    **B32B 9/00** (2006.01)
**C23C 14/24** (2006.01)    **C23C 14/30** (2006.01)

(86) International application number:
**PCT/JP2018/028076**

(87) International publication number:
**WO 2019/031262 (14.02.2019 Gazette 2019/07)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **10.08.2017  JP 2017155060**

(71) Applicant: **Toyobo Co., Ltd.**
**Osaka-shi, Osaka 530-8230 (JP)**

(72) Inventors:
• **KASHIWA, Mitsuhiro**
  **Otsu-shi**
  **Shiga 520-0292 (JP)**
• **NUMATA, Yukihiro**
  **Otsu-shi**
  **Shiga 520-0292 (JP)**
• **ISEKI, Kiyoshi**
  **Otsu-shi**
  **Shiga 520-0292 (JP)**

(74) Representative: **Vossius & Partner**
**Patentanwälte Rechtsanwälte mbB**
**Siebertstrasse 3**
**81675 München (DE)**

(54) **GAS BARRIER FILM PRODUCTION METHOD**

(57)    To provide a production method that enables to produce a gas barrier film having excellent transparency and gas barrier properties at high speed. A method for producing a gas barrier film, the gas barrier film having an inorganic thin-film layer laminated to at least one of surfaces of a polymer substrate, in which the inorganic thin-film layer is formed by a vacuum vapor-deposition method using A1 and $SiO_2$ as vapor-deposition materials while introducing oxygen gas.

EP 3 666 922 A1

**Description**

TECHNICAL FIELD

The present invention relates to a method for producing a transparent gas barrier film to be used as a packaging material for food, pharmaceutical products, electronic components and the like.

BACKGROUND ART

Recently, packaging materials to be used for food, pharmaceutical products, electronic components and the like have been required to prevent penetration of gas such as oxygen and water vapor so as to inhibit oxidation, deterioration, corrosion and the like of their contents, so that a packaging material having gas barrier properties for blocking these kinds of gas has been sought.

As a film having excellent gas barrier properties, a plastic film with aluminum (hereinafter, called as Al) laminated thereto and a plastic film coated with vinylidene chloride or ethylene-vinyl alcohol copolymer have been known. Further, as a film utilizing an inorganic thin-film, a film with a thin-film of silicon oxide, aluminum oxide or the like laminated thereto has been known.

The above-described conventional gas barrier films have had following problems. Although the aluminum laminate is economically superior and has excellent gas barrier properties, it is opaque so as not to allow the packaged content of the aluminum laminate to be seen through, and does not allow microwaves to permeate through and thus cannot be used in a microwave oven. Also, if aluminum is contained in a part of configurations of such packaging materials and packages, the plastic films have a problem that they cannot be recovered and recycled. The film coated with vinylidene chloride or ethylene-vinyl alcohol copolymer has insufficient gas barrier properties of water vapor, oxygen or the like, and the degradation is considerable particularly in a high temperature process such as a boiling process and a retorting process. Further, vinylidene chlorides generate chlorine gas during incineration, so that the influence on global environment is also concerned.

In order to overcome these problems, a transparent vapor-deposition film obtained by forming a ceramic thin-film onto a substrate made of a transparent polymer material by a method such as a vacuum vapor-deposition method has been released recently.

As a material for this ceramic thin-film, silicon oxide such as silicon monoxide and aluminum oxide (hereinafter, called as $Al_2O_3$) are often used. However, silicon oxide which exhibits favorable gas barrier properties is colored in slight brown, and is insufficient as a transparent gas barrier film. Further, an evaporating temperature of a raw material of $Al_2O_3$ is high, so that the evaporation speed in a vapor-deposition process becomes low. Thus, for adhering a thin-film thickness sufficient for providing the required gas barrier properties, a thin-film formation time becomes long, and production efficiency becomes low, thereby increasing the cost.

In order to solve this problem, Patent Document 1 proposes a method for substantially providing a thin-film of $Al_2O_3$ onto a substrate film, by using Al as a vapor-deposition material and introducing oxygen gas into a vapor-deposition apparatus so as to react oxygen gas with Al.

However, this technique has had a problem that, since the $Al_2O_3$ thin-film is brittle, when it is used for packaging, flaws are generated by being bent or the like, whereby the gas barrier properties degrade.

In order to solve this problem, in Patent Document 2, a method for forming a film that has excellent flex resistance, by mixing $Al_2O_3$ with silicon oxide so as to form a thin-film of complex oxide, has been developed.

PRIOR ART DOCUMENTS

PATENT DOCUMENTS

Patent Document 1: JP-A-2001-6442
Patent Document 2: JP-A-H7-242760

SUMMARY OF THE INVENTION

PROBLEMS TO BE SOLVED BY THE INVENTION

Patent Document 2 proposes a method for forming a thin-film of complex oxide by partitioning Al and silicon dioxide (hereinafter, called as $SiO_2$), which are vapor-deposition materials, into two by a carbon plate, and heating each of the materials by time division. However, on the way to proceed the study, the inventors of the present invention have found problems that heating efficiency is deteriorated and thin-film formation speed is not increased by this method.

An object of the present invention is to provide a production method that enables to produce a gas barrier film having excellent transparency and gas barrier properties at high speed.

MEANS FOR SOLVING THE PROBLEMS

As a result of the keen study with regard to the problems of this conventional art, the inventors have reached the present invention. That is, in the method for producing a transparent gas barrier film using Al and $SiO_2$ as the vapor-deposition materials, by introducing oxygen gas and putting Al into a crucible with low thermal conductivity so as to partition the respective vapor-deposition materials, thermal dispersion can be decreased, whereby the vapor-deposition materials can be heated efficiently. The inventors have found that the heating efficiency can be increased and the thin-film formation speed can be improved as a result.

The present inventors have found that the above-described problems can be solved by following means, thereby reaching the present invention. That is, the present invention includes following configurations.

1. A method for producing a gas barrier film, the gas barrier film having an inorganic thin-film layer laminated to at least one of surfaces of a polymer substrate, in which the inorganic thin-film layer is formed by a vacuum vapor-deposition method using Al and $SiO_2$ as vapor-deposition materials while introducing oxygen gas.

2. The method for producing a gas barrier film according to 1., in which the vapor-deposition materials are heated by an electron gun heating method in the vacuum vapor-deposition method.

3. The method for producing a gas barrier film according to any one of 1. to 2., in which, in the vacuum vapor-deposition method, a vacuum vapor-deposition apparatus to be used has a hearth and has a crucible in the hearth, vapor-deposition materials of Al and $SiO_2$ are partitioned between an inside and an outside of the crucible, and the vapor-deposition materials are heated separately so as to form the inorganic thin-film layer.

4. The method for producing a gas barrier film according to 3., in which, in the vacuum vapor-deposition method, the crucible is mainly made of $Al_2O_3$.

5. The method for producing a gas barrier film according to any one of 1. to 4., in which, in the vacuum vapor-deposition method, oxygen gas is introduced via a pipe.

6. The method for producing a gas barrier film according to 5., in which oxygen gas is supplied between the polymer substrate and the vapor-deposition material via the pipe.

7. The method for producing a gas barrier film according to any one of 1. to 6., in which, in the vacuum vapor-deposition method, the vapor-deposition materials are heated by the electron gun heating method, and when time ratios of heating Al and $SiO_2$ by time division are respectively denoted as a and b, a relation of a < b and 2a > b is satisfied.

EFFECT OF THE INVENTION

In the method for producing a gas barrier film using Al and $SiO_2$ as vapor-deposition materials of the present invention, by introducing oxygen gas and putting Al into a crucible so as to partition the respective vapor-deposition materials, thermal dispersion can be decreased, and the vapor-deposition materials can be heated efficiently, whereby the thin-film formation speed can be improved. That is, the present invention can provide a production method for producing a gas barrier film at high speed by using Al and $SiO_2$ as the vapor-deposition materials. In addition, the gas barrier film formed in the present invention can be provided as a packaging material for food, pharmaceutical products, electronic components and the like.

BRIEF DESCRIPTION OF THE DRAWINGS

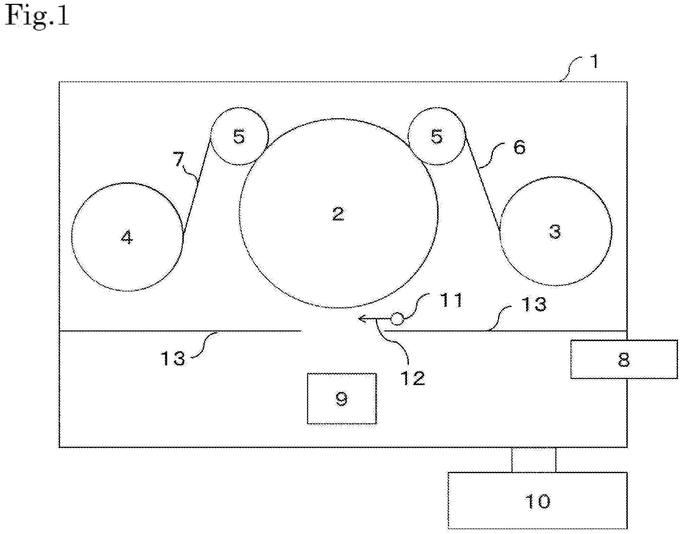

Fig. 1 is a view showing a vacuum vapor-deposition apparatus which is used in Examples 1 and 2 of the present invention.

MODE FOR CARRYING OUT THE INVENTION

Hereinafter, the present invention will be described in detail.

A polymer substrate in the present invention is a film-shaped substrate which is obtained by melt-extruding organic polymer, stretching the organic polymer in a longitudinal direction and/or a transverse direction as necessary, and cooling and thermosetting the organic polymer. As the organic polymer, polyethylene, polypropylene, polyethylene terephthalate, polybutylene terephthalate, polyethylene-2,6-naphthalate, nylon 6, nylon 4, nylon 66, nylon 12, polyvinyl chloride, polyvinylidene chloride, polyvinyl alcohol, wholly aromatic polyamide, polyamide imide, polyimide, polyether imide, polysulfone, polyphenylene sulfide, polyphenylene oxide, and the like can be exemplified. Among the above organic polymers, in the light of low thermal shrinkage and low moisture absorbing expansibility, polyethylene terephthalate is preferable. Also, these kinds of organic polymer may be copolymerized or blended with a small amount of other kind of organic polymer.

Further, to this organic polymer, publicly known additives such as, for example, a ultraviolet absorber, an anti-static agent, a plasticizer, a lubricant and a coloring agent may be added, and then, transparency of the organic polymer is not limited particularly, but if the organic polymer is used as a transparent gas barrier film, the total light transmittance in the organic polymer is 50% or more, is preferably 70% or more, and is further preferably 85% or more.

As the polymer substrate of the present invention, the film may be subjected to corona discharge treatment, glow discharge treatment or other surface roughening treatment, and may also be subjected to anchor coat treatment, or may be printed or decorated before laminating a thin-film layer thereto, as far as not losing the object of the present invention.

The polymer substrate of the present invention has a thickness that preferably ranges from 5 μm to 200 μm, more preferably ranges from 8 μm to 50 μm, and particularly preferably ranges from 10 μm to 30 μm.

Further, the substrate layer in the present invention may be a laminated film of two layers or more. In the case of adopting as a laminated film, a kind, the number of layers of lamination, a lamination method and the like of the laminate are not limited particularly, and may be selected arbitrarily from publicly known methods according to the purpose.

The inorganic thin-film layer in the present invention uses Al and $SiO_2$ as the vapor-deposition materials, and thus mainly contains elements of Al, Si and O, and the ratio of the elements varies according to formation conditions. In addition, in these components, a slight amount (3% or less with respect to the total components) of other component may be contained to an extent that does not lose the properties. A thickness of the inorganic thin-film layer is preferably 5 nm to 100 nm, and is further preferably 7 nm to 40 nm, in the light of the gas barrier properties and flexibility.

For forming the inorganic thin-film layer, a vacuum vapor-deposition method is adopted. In the present invention, Al and $SiO_2$ are used as vapor-deposition material sources, and beside Al and $SiO_2$, silicon monoxide (SiO), aluminum oxide ($Al_2O_3$) and the like may be mixed. Al can be transformed also into oxide such as AlO and $Al_2O_3$ by oxidation. $SiO_2$ can be transformed into silicon or silicon oxide such as SiO or Si by reduction.

Further, respective particles are required to have an appropriate size so as not to change pressure during the vapor-deposition. A range of the particle size is preferably 3 mm or larger and 20 mm or smaller, and is further preferably 3 mm or larger and 10 mm or smaller. If the particle diameter is too large, evaporation takes time from start of heat application, whereby change of pressure becomes larger. On the other hand, if the particle diameter is too small, explosive boil is caused, and the particles are attached to the film, whereby degradation in quality of appearance may be caused, or flaws may be generated to the thin-film.

The respective vapor-deposition materials are partitioned by a crucible in a hearth. Since Al has high thermal conductance, heat conducts between Al particles quicker than the temperature of Al particles reaching an evaporating temperature, whereby the temperature is increased to the evaporating temperature after liquefying all of the Al particles. Thus, if the materials are divided just by the partition plate, liquid Al may flow through a gap or the like. By partitioning the materials by the crucible, it is possible not only to decrease thermal dispersion so as to increase heating efficiency, but also to inhibit outflow of the liquid Al. A kind of the crucible is not limited particularly, but for example, a crucible that is mainly made of $Al_2O_3$ is preferable, and a crucible which is mainly made of $Al_2O_3$ and has holes is further preferable, in the light of heat resistance and thermal insulation.

Thin-film formation speed during the vapor-deposition is preferably 100 m/min or more in the light of the production cost. Further, the evaporation speed of the materials is not limited particularly, because it is necessary to be changed according to the thin-film formation speed, but the evaporation speed that is calculated by a calculation method described in below-described Examples preferably ranges from 15 μm/min/A to 200 μm/min/A, further preferably ranges from 15 μm/min/A to 100 μm/min/A, and particularly preferably ranges from 20 μm/min/A to 80 μm/min/A. If the evaporation speed is too low, the thin-film formation speed cannot be increased, and if the evaporation speed is too high, control of the pressure becomes difficult.

A weight ratio of Al atoms : Si atoms is preferably within a range from 10 : 90 to 50 : 50, and is further preferably within a range from 20 : 80 to 40 : 60. If the Al ratio is too low, the gas barrier properties are not exhibited, and the Al ratio is too high, the thin-film is likely to be colored, so that the application as the transparent gas barrier film is limited.

As a heating method, an electron gun heating method is preferable, because it has a merit that a heating quantity change quickly responds to a change of scanning and a current value, but the heating method is not limited to this method, and resistance heating, high frequency induction heating, laser heating and the like can also be adopted. Further, reactive gas can be introduced into a thin-film formation apparatus. In this case, the reactive gas to be introduced is preferably transformed into plasma. As the reactive gas, oxygen gas is used, and beside the oxygen gas, nitrogen, hydrogen, water vapor or the like may be introduced, and means such as ozone addition and ion assist may also be adopted thereto.

When the vapor-deposition materials are heated by the electron gun heating method, if time ratios of heating Al and $SiO_2$ by time division are respectively denoted as a and b, preferably the relation of a < b and 2a > b is satisfied. More preferably, the relation of a < b and 1.5a ≥ b is satisfied. If the vapor-deposition is carried out in the condition of a > b, the thin-film is likely to be colored, but in the condition of 2a < b, an evaporation amount of $SiO_2$ becomes excessive, and the vapor-deposited particles are considered to inhibit a reaction between Al and oxygen gas.

Fig. 1 illustrates the vacuum vapor-deposition apparatus of the present invention. In a vacuum chamber 1, an unwinding portion 3 and a winding portion 4 are disposed via a cooling drum 2 and guide rolls 5. The two guide rolls are illustrated, but the number of the guide rolls is not limited to this.

The reactive gas is introduced into the vacuum chamber 1 using a pipe 11. A shape of the pipe and the gas introduction position of the pipe are not limited particularly, but in the light of the reactivity, it is preferable to dispose the pipe so that the gas may be supplied between a crucible 9 in which the vapor-deposition material is disposed and the cooling drum 2 on which the substrate runs, as shown by a reactive gas introduction direction 12. Further, the pipe 11 is preferably covered with an attachment prevention plate 13 so that the vapor-deposition materials may not be attached thereto.

An introduction mount of the oxygen gas is not limited particularly, because it is changed according to the evaporation amount of the vapor-deposition materials, but it is preferably adjusted so that pressure in the vacuum chamber 1 during the thin-film formation may be $5.0 \times 10^{-1}$ Pa or lower, and further preferably, the pressure may be $1.0 \times 10^{-1}$ Pa or lower.

An emission current of the electron gun is preferably 0.3 A or higher and 1.5 A or lower, is further preferably 0.3 A or higher and 1.0 A or lower, and is more preferably 0.3 A or higher and 0.8 A or lower. If the emission current is lower than 0.3 A, sufficient evaporation speed cannot be obtained, thereby decreasing the productivity. On the other hand, if the emission current is too high, decomposition of the silicon oxide becomes large, whereby control of the pressure becomes difficult.

In the present invention, the thin-film may be formed only on one of surfaces of the plastic film, but may be formed on both of the surfaces. Further, the formation conditions may be changed by adding a bias to the substrate or the like, as far as not losing the object of the present invention.

The gas barrier film produced by the production method of the present invention may be used as it is, and may also be used after being laminated or coated with a film or a thin layer of other organic polymer.

For example, in the case of using the gas barrier film produced by the production method of the present invention for packaging, it may be laminated with various kinds of films or paper depending on properties required for a content to be packaged, and as a representative laminate configuration thereof, the gas barrier film (PET upper side) / PE, the gas barrier film (PET upper side) / CPP, NY / the gas barrier film (PET upper side) / PE, the gas barrier film (NY upper side) / PE and the like can be considered. A lamination method thereof is not limited particularly, but dry lamination, an extrusion lamination method and the like are preferable. Further, decoration and printing for content description may be added thereto, or a design film, a reinforcing material and the like may be adhered thereto.

As the gas barrier properties of the laminate of the present invention, an oxygen permeation amount under the environment at a temperature of 23°C and relative humidity of 65% RH is preferably 1.0 $ml/m^2/24H/MPa$ or higher and 100 $ml/m^2/24H/MPa$ or lower. It is less preferable that the gas barrier properties are higher than 100 $ml/m^2/24H/MPa$, because such a laminated body is hard to be used for food, pharmaceutical products, industrial products and the like. Further, although the lower the gas barrier properties are, the better, a lower limit of the barrier properties in the present configuration is 1.0 $ml/m^2/24H/MPa$ in the current technical level, and even gas barrier properties of 1.0 $ml/m^2/24H/MPa$ are practically sufficient. A more preferable range thereof is 1.0 $ml/m^2/24H/MPa$ or higher and 70 $ml/m^2/24H/MPa$ or lower, and a particularly preferable range is 1.0 $ml/m^2/24H/MPa$ or higher and 30 $ml/m^2/24H/MPa$ or lower.

EXAMPLES

The present invention will be specifically described below by way of examples, but the present invention is not limited to the examples.

Hereinafter, measurements and operating procedures carried out in the examples will be described.

1) Calculation of thin-film thickness and ratio of Al and Si

A thin-film thicknesses and a ratio of Al and Si were measured by using an X-ray fluorescence spectrometer (System 3270 produced by Rigaku Corporation). X-rays were generated by a rhodium bulb at 50 kV and 50 mA, and a composite thin-film of $Al_2O_3/SiO_2$ was quantified using a calibration curve which was formed based on samples with different composition ratios.

2) Calculation of evaporation speed

Evaporation speed (hereinafter, abbreviated as ES) was obtained by using a following formula.

```
Evaporation Speed: ES = T/(0.15/(LS/60)) × 60/1000/A
```

Herein, T denotes a thin-film thickness (nm), LS denotes thin-film formation speed (m/min), and A denotes a current value (A) of EB.

3) Oxygen permeability

Oxygen permeability of the formed gas barrier film was measured by an oxygen permeability measurement device (OX-TRAN100 produced by ModernControls, Inc.) under conditions at 23°C and 65% R.H.

4) Light transmittance

Total light transmittance was measured by a hazemeter (hazemeter produced by NIPPON DENSHOKU INDUSTRIES CO., LTD, NDH5000).

(Example 1)

A composite oxide thin-film was formed on a PET film (TOYOBO CO., LTD.: E5100) with a thickness of 12 $\mu$m by a vacuum vapor-deposition apparatus shown in Fig. 1, using particulate Al (purity: 99.9%) of about 7 mm to about 9 mm and $SiO_2$ (purity: 99.9%) of about 4 mm to about 7 mm as vapor deposition sources. The above-described two kinds of the vapor-deposition materials were not mixed but were partitioned by putting Al into a crucible which was made of $Al_2O_3$ and had holes and putting $SiO_2$ around the crucible in a hearth. One electron gun was used as a heat source so as to heat each of Al and $SiO_2$ by time division. An output of electron beams was 0.7 A, a heating ratio (time ratio) of Al and $SiO_2$ was 40 : 60, and feeding speed of the film was 150 m/min, thereby forming the composite thin-film with a thickness of 26.7 nm. A flow rate of oxygen gas was 50 sccm, and pressure during the vapor-deposition was $6.0 \times 10^{-2}$ Pa. Further, a temperature of a coating roll for cooling the film during the vapor-deposition was adjusted at -10°C, thereby obtaining the gas barrier film of the present invention. These thin-film formation conditions will be shown in Table 1.
A thin-film thickness and a ratio of Al and Si of the thus obtained gas barrier film were measured by an X-ray fluorescence spectrometer, oxygen permeability was measured as the gas barrier properties, and light transmittance was measured as an optical property. These measurement results will be shown in Fig. 2.

(Example 2)

A composite oxide thin-film was formed on a PET film (TOYOBO CO., LTD.: E5100) with a thickness of 12 $\mu$m by the vacuum vapor-deposition apparatus shown in Fig. 1, using particulate Al (purity: 99.9%) of about 7 mm to about 9 mm and $SiO_2$ (purity: 99.9%) of about 4 mm to about 7 mm as the vapor deposition sources. The above-described two kinds of the vapor-deposition materials were not mixed but were partitioned by putting Al into a crucible made of MgO and putting $SiO_2$ around the crucible in a hearth. One electron gun was used as a heat source so as to heat each of Al and $SiO_2$ by time division. An output of electron beams was 0.6 A, a heating ratio (time ratio) of Al and $SiO_2$ was 49 : 51, and feeding speed of the film was 120 m/min, thereby forming the composite thin-film with a thickness of 13.6 nm. A flow rate of oxygen gas was 150 sccm, and pressure during the vapor-deposition was $1.0 \times 10^{-1}$ Pa. Further, a temperature of a coating roll for cooling the film during the vapor-deposition was adjusted at -10°C, thereby obtaining the gas barrier film of the present invention. These thin-film formation conditions will be shown in Table 1.
A thin-film thickness and a ratio of Al and Si of the thus obtained gas barrier film were measured by an X-ray fluorescence spectrometer, oxygen permeability was measured as the gas barrier properties, and light transmittance was measured as the optical property. These measurement results will be shown in Fig. 2.

(Comparative Example 1)

A composite oxide thin-film was formed on a PET film (TOYOBO CO., LTD.: E5100) with a thickness of 12 $\mu$m by the vacuum vapor-deposition apparatus shown in Fig. 1, using particulate Al (purity: 99.9%) of about 7 mm to about 9 mm and $SiO_2$ (purity: 99.9%) of about 4 mm to about 7 mm as the vapor deposition sources. The above-described two kinds of the vapor-deposition materials were not mixed, but an inside of a hearth was partitioned into two by a carbon plate so as to separate the materials. One electron gun was used as a heat source so as to heat each of Al and $SiO_2$ by time division. An output of electron beams was 2.0 A, a heating ratio (time ratio) of Al and $SiO_2$ was 11 : 89, and feeding speed of the film was 50 m/min, thereby forming a thin-film with a thickness of 79 nm. A flow rate of oxygen gas was 100 sccm, and pressure during the vapor-deposition was $1.1 \times 10^{-1}$ Pa. Further, a temperature of a coating roll for cooling the film during the vapor-deposition was adjusted at -10°C, thereby obtaining the gas barrier film of the present invention. These thin-film formation conditions will be shown in Table 1. The obtained gas barrier film was subjected to measurements similar to those of Example 1. The measurement results will be shown in Fig. 2.

(Comparative Example 2)

A composite oxide thin-film was formed on a PET film (TOYOBO CO., LTD.: E5100) with a thickness of 12 $\mu$m by the vacuum vapor-deposition apparatus shown in Fig. 1, using particulate Al (purity: 99.9%) of about 7 mm to about 9 mm and $SiO_2$ (purity: 99.9%) of about 4 mm to about 7 mm as the vapor deposition sources. The above-described two kinds of the vapor-deposition materials were not mixed, but an inside of a hearth was partitioned into two by a carbon plate so as to separate the materials. One electron gun was used as a heat source so as to heat each of Al and $SiO_2$ by time division. An output of electron beams was 2.0 A, a heating ratio (time ratio) of Al and $SiO_2$ was 9 : 91, and feeding speed of the film was 50 m/min, thereby forming a thin-film with a thickness of 85 nm. A flow rate of oxygen gas was 300 sccm, and pressure during the vapor-deposition was $1.3 \times 10^{-1}$ Pa. Further, a temperature of a coating roll for cooling the film during the vapor-deposition was adjusted at -10°C, thereby obtaining the gas barrier film of the present invention. These thin-film formation conditions will be shown in Table 1. The obtained gas barrier film was subjected to measurements similar to those of Example 1. The measurement results will be shown in Fig. 2.

(Comparative Example 3)

A composite oxide thin-film was formed on a PET film (TOYOBO CO., LTD.: E5100) with a thickness of 12 $\mu$m by the vacuum vapor-deposition apparatus shown in Fig. 1, using particulate Al (purity: 99.9%) of about 7 mm to about 9 mm and $SiO_2$ (purity: 99.9%) of about 4 mm to about 7 mm as the vapor deposition sources. The above-described two kinds of the vapor-deposition materials were not mixed, but an inside of a hearth was partitioned into two by a carbon plate so as to separate the materials. One electron gun was used as a heat source so as to heat each of Al and $SiO_2$ by time division. An output of electron beams was 2.0 A, a heating ratio (time ratio) of Al and $SiO_2$ was 11 : 89, and feeding speed of the film was 50 m/min, thereby forming a thin-film with a thickness of 78 nm. A flow rate of oxygen gas was 60 sccm, and pressure during the vapor-deposition was $6.0 \times 10^{-2}$ Pa. Further, a temperature of a coating roll for cooling the film during the vapor-deposition was adjusted at -10°C, thereby obtaining the gas barrier film of the present invention. These thin-film formation conditions will be shown in Table 1. The obtained gas barrier film was subjected to measurements similar to those of Example 1. The measurement results will be shown in Fig. 2.

[Table 1]

| | Thin-film formation speed (m/min) | Current value (A) | Oxygen flow rate (sccm) | Pressure (Pa) | Partition | Heating ratio | |
| --- | --- | --- | --- | --- | --- | --- | --- |
| | | | | | | a | b |
| Example 1 | 150 | 0.7 | 50 | 0.06 | $Al_2O_3$ crucible | 40 | 60 |
| Example 2 | 120 | 0.6 | 150 | 0.10 | MgO crucible | 49 | 51 |
| Comparative Example 1 | 50 | 2.0 | 100 | 0. 11 | Carbon plate | 11 | 89 |
| Comparative Example 2 | 50 | 2.0 | 300 | 0.13 | Carbon plate | 9 | 91 |
| Comparative Example 3 | 50 | 2.0 | 60 | 0.06 | Carbon plate | 11 | 89 |

[Table 2]

| | Composition ratio | | Thin-film thickness (nm) | Evaporation speed ($\mu$m/min/A) | Oxygen permeability (ml/m$^2$/ 24H/MPa) | Total light transmittanc e (%) |
|---|---|---|---|---|---|---|
| | Al % by mass | Si % by mass | | | | |
| Example 1 | 26 | 74 | 26.7 | 38.1 | 8.4 | 88 |
| Example 2 | 44 | 56 | 13.6 | 18.1 | 25.8 | 84 |
| Comparative Example 1 | 38 | 62 | 79.0 | 13.2 | 5.2 | 86 |
| Comparative Example 2 | 4 | 96 | 85.0 | 14.2 | 72.0 | 88 |
| Comparative Example 3 | 50 | 50 | 78.0 | 13.0 | 4.1 | 86 |

Table 2 shows that the gas barrier films obtained in Examples 1 to 2 were formed at the high evaporation speed, which were as high as 38.1 $\mu$m /min/A and 18.1 $\mu$m /min/A, respectively. Further, the gas barrier films obtained in Examples 1 to 2 exhibited the oxygen permeability of 30 ml/m$^2$/24H/MPa or less and the total light transmittance of 80% or more, and thus had sufficient performances as transparent gas barrier films. On the other hand, in Comparative Examples 1 to 3, since the two kinds of the vapor-deposition materials were partitioned by the carbon plate, the heating efficiency was low, so that the evaporation speed was as low as 13.0 $\mu$m/min/A to 14.2 $\mu$m/min/A.

INDUSTRIAL APPLICABILITY

The present invention enables to produce a gas barrier film having excellent gas barrier properties and transparency at high speed, and thus can be used favorably as a method for producing a packaging film, which is used in a packaging field for food, pharmaceutical products, precise electronic components and the like.

DESCRIPTION OF REFERENCE SIGNS

1    VACUUM CHAMBER
2    COOLING DRUM
3    UNWINDING PORTION
4    WINDING PORTION
5    GUIDE ROLL
6    SUBSTRATE FILM
7    INORGANIC THIN-FILM LAYER LAMINATE
8    ELECTRON GUN
9    HEARTH
10   VACUUM PUMP
11   REACTIVE GAS INTRODUCTION PIPE
12   REACTIVE GAS INTRODUCTION DIRECTION
13   ATTACHMENT PREVENTION PLATE

**Claims**

1.  A method for producing a gas barrier film,
    the gas barrier film having an inorganic thin-film layer laminated to at least one of surfaces of a polymer substrate, wherein the inorganic thin-film layer is formed by a vacuum vapor-deposition method using Al and SiO$_2$ as vapor-deposition materials while introducing oxygen gas.

2.  The method for producing a gas barrier film according to claim 1, wherein the vapor-deposition materials are heated by an electron gun heating method in the vacuum vapor-deposition method.

3. The method for producing a gas barrier film according to any one of claims 1 to 2, wherein, in the vacuum vapor-deposition method, a vacuum vapor-deposition apparatus to be used has a hearth and has a crucible in the hearth, vapor-deposition materials of Al and $SiO_2$ are partitioned between an inside and an outside of the crucible, and the vapor-deposition materials are heated separately so as to form the inorganic thin-film layer.

4. The method for producing a gas barrier film according to claim 3, wherein, in the vacuum vapor-deposition method, the crucible is mainly made of $Al_2O_3$.

5. The method for producing a gas barrier film according to any one of claims 1 to 4, wherein, in the vacuum vapor-deposition method, oxygen gas is introduced via a pipe.

6. The method for producing a gas barrier film according to claim 5, wherein oxygen gas is supplied between the polymer substrate and the vapor-deposition material via the pipe.

7. The method for producing a gas barrier film according to any one of claims 1 to 6, wherein, in the vacuum vapor-deposition method, the vapor-deposition materials are heated by the electron gun heating method, and when time ratios of heating Al and $SiO_2$ by time division are respectively denoted as a and b, a relation of $a < b$ and $2a > b$ is satisfied.

Fig.1

## INTERNATIONAL SEARCH REPORT

| International application No. |
| --- |
| PCT/JP2018/028076 |

A. CLASSIFICATION OF SUBJECT MATTER
Int.Cl.    C23C14/08(2006.01)i,   B32B9/00(2006.01)i,   C23C14/24(2006.01)i,
           C23C14/30(2006.01)i
According to International Patent Classification (IPC) or to both national classification and IPC

B.   FIELDS SEARCHED

Minimum documentation searched (classification system followed by classification symbols)
Int.Cl. C23C14/08, B32B9/00, C23C14/24, C23C14/30

| Documentation searched other than minimum documentation to the extent that such documents are included in the fields searched | |
| --- | --- |
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
| --- | --- | --- |
| X<br>Y | JP 7-242760 A (TOYOBO BOSEKI KABUSHIKI KAISHA) 19 September 1995, claims, paragraph [0034], table 1 (Family: none) | 1-2<br>3-7 |
| Y | JP 2017-20056 A (SHINKO SEIKI CO., LTD.) 26 January 2017, paragraphs [0014], [0064], fig. 4 (Family: none) | 3-7 |
| Y | JP 2004-197171 A (NIPPON STEEL CORP.) 15 July 2004, claims (Family: none) | 4-7 |
| Y | JP 2001-341225 A (TOPPAN PRINTING CO., LTD.) 11 December 2001, paragraph [0050] (Family: none) | 5-7 |

☐   Further documents are listed in the continuation of Box C.　　☐   See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 27 September 2018 (27.09.2018) | 09 October 2018 (09.10.2018) |

| Name and mailing address of the ISA/<br>Japan Patent Office<br>3-4-3, Kasumigaseki, Chiyoda-ku,<br>Tokyo 100-8915, Japan | Authorized officer |
| --- | --- |
| | Telephone No. |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001006442 A

- JP H7242760 A